# EUROPEAN PATENT APPLICATION

(11) **EP 3 358 685 A1**
(43) Date of publication of application: **08.08.2018**
(21) Application number: 17305143.4
(22) Date of filing: 07.02.2017
(51) Int. Cl.: H01S 5/50, H04B 10/43, H01S 5/026, H04J 14/02

(54) **SELF-SEEDED TRANSCEIVER FOR WDM OPTICAL NETWORK**

(71) Applicant: Alcatel Lucent, 91620 Nozay (FR)
(72) Inventor: BRENOT, Romain, 91767 PALAISEAU (FR); ACHOUCHE, Mohand, 91767 PALAISEAU (FR); BARBET, Sophie, 91767 PALAISEAU (FR)
(74) Representative: Novagraaf Technologies

(57) **Abstract**

The present invention relates a transceiver for a self-seeded laser source (200) for Wavelength Division Multiplexing Passive Optical Network comprising on a same chip:
- a receiver (240) adapted to receive the data information carried by an optical signal; and
- a Reflecting Semiconductor Amplifier (230) comprising a reflecting element (270) adapted to form a mirror for the self-seeded laser cavity, and adapted to amplify the optical signal before the input of the receiver (240).

It offers a high flexibility and an innovative solution for Wavelength Division Multiplexing Passive Optical Network, by keeping the same upstream transceiver and Passive Optical Network architecture, in addition to being low cost and easy to manufacture and implement.

## Description

### SPECIFICATION

### Field of the Invention

The present invention relates to a self-seeded laser source for Wavelength Division Multiplexing (WDM) Passive Optical Network (PON).

### Background

Self-tuned (or self-seeding) laser cavities are a low cost solution for large channel count fiber links in telecommunication, and are a potential candidate for mobile front-haul or back-haul, or for datacoms.

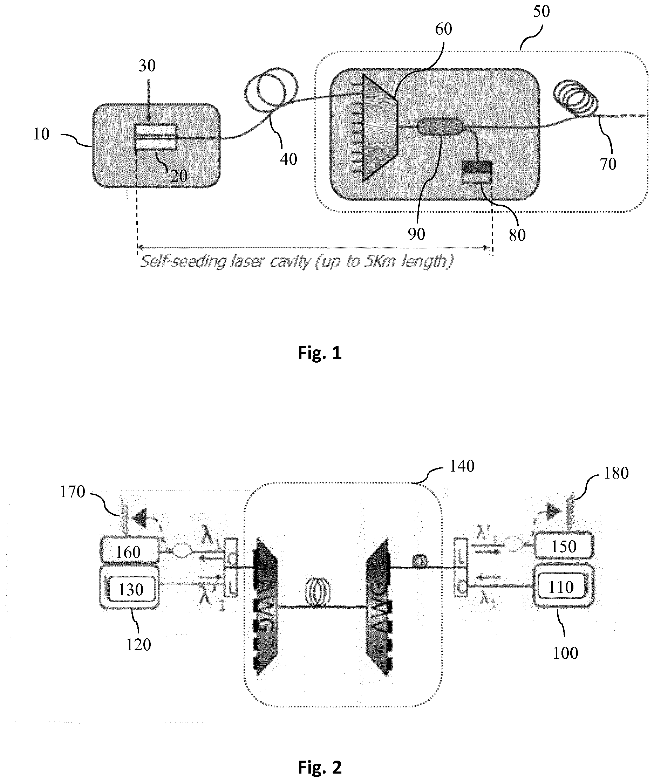

The standard configuration currently used is illustrated in figure 1.

This configuration comprises a colorless transmitter 10 comprising a Reflecting Semiconductor Amplifier (RSOA) 20 which is adapted to generate an optical signal that is modulated via an electrical signal 30 received by the RSOA 20.

Then the optical signal is injected, using a distribution fiber 40, in a Passive Optical Network (PON) 50 comprising at its entrance an Arrayed Waveguide Grating (AWG) 60, followed by a feeder fiber 70.

In order to close the self-seeding laser cavity, this configuration requires the insertion of a remote mirror 80 in a remote node 90 located after an Array Wavelength Grating 60, so in the PON 50, which is a major drawback. In fact, in the case of multiple services on the same infrastructure, this would impact the other users, and hence reduce the interoperability.

An alternative architecture, without any mirror on the PON (Passive Optical Network), is disclosed in [R1] and illustrated in Figure 2.

Figure 2 shows a symmetrical WDM PON architecture with a transmitter 100 comprising a RSOA 110 and working at a wavelength λ₁ for the uplink and a transmitter 120 comprising a RSOA 130 working at a wavelength λ'₁ for the downlink.

On each side of the WDM PON 140, a receiver is associated to each transmitter: receiver 150 is associated with transmitter 120 and receiver 160 is associated with transmitter 100.

Above the receivers 150 and 160, there are an amplifier (not represented) and a mirror 170 and 180. The role of these elements is to close the cavity, to provide a sufficient gain for lasing, and to erase the upstream data before recirculating in the PON. This leads to a complex transceiver, which increases the cost and consequently the applicability of this option.

There is a need for an self-seeded laser architecture simpler, low cost, and easy to implement and without having to change the PON architecture.

### Summary

The present invention proposes firstly a transceiver and secondly a self-seeded laser source for Wavelength Division Multiplexing (WDM) Passive Optical Network (PON) which solve the prior art drawbacks.

In a first general transceiver embodiment, the transceiver for Wavelength Division Multiplexing Passive Optical Network comprises :
- a receiver adapted to receive the data information carried by an optical signal and
- a Reflecting Semiconductor Amplifier for amplifying the optical signal, comprising a reflecting element adapted to reflect the optical signal, the Reflecting Semiconductor Amplifier being adapted to erase data after the optical signal has been amplified and reflected on the reflecting element,
characterized in that
the Reflecting Semiconductor Amplifier is integrated in a single chip with the receiver.

Advantageously, the receiver and the Reflecting Semiconductor Amplifier are integrated by using a bi-electrode device comprising two sections, one section been positively biased for providing gain and ensuring data cancellation by gain compression and defining the Reflecting Semiconductor Amplifier section, and a second shorter section been negatively biased for detecting the incoming optical signal defining the receiver section.

According to a first option, the receiver section is located between the reflecting element and the Reflecting Semiconductor Amplifier section.

According to a second option, the reflecting element is located between the Reflecting Semiconductor Amplifier section and the receiver section.

In this second option, the reflecting element can be indifferently made with:
- an etched gap between both sections;
- photonic crystals; or
- a Bragg grating.

In a second transceiver embodiment, the single chip comprises a two by one coupler adapted to split the optical signal in two substantially identical signals each containing the data information, one being sent to the receiver and the other being sent to the Reflecting Semiconductor Amplifier.

Advantageously, the two by one coupler is a Multi-Mode Interferometer.

The present invention further relates to a self-seeded laser source for Wavelength Division Multiplexing Passive Optical Network comprising :
- a first Reflecting Semiconductor Amplifier comprising a reflecting element, and adapted to generate an optical signal and adapted to modulate it; and
- a transceiver according to one of the embodiments previously described, wherein the reflecting elements form the self-seeded laser cavity.

### Brief Description of the Drawings

Some embodiments of apparatus in accordance with embodiments of the present invention are now described, by way of example only, and with reference to the accompagnying drawings, in which :
- The Figure 1 schematically illustrates a current self-seeding laser cavity used in a WDM PON.
- The Figure 2 schematically illustrates a prior art architecture of a self-tuning laser for WDM PON;
- The Figure 3 schematically illustrates an embodiment of the present invention;
- The Figure 4 schematically illustrates another embodiment of the present invention;
- The Figures 5A and 5B schematically illustrate two embodiments of a single chip as proposed in the present invention;
- The Figure 6 schematically illustrates another embodiment of a single chip as proposed in the present invention;

### Description of Embodiments

As previously described, there is a need for a simplifed architecture easy to implement and without having to change the PON architecture.

The description below describes the invention through a self-seeded laser, but the invention also relates to the elements which constitute the self-seeded laser.

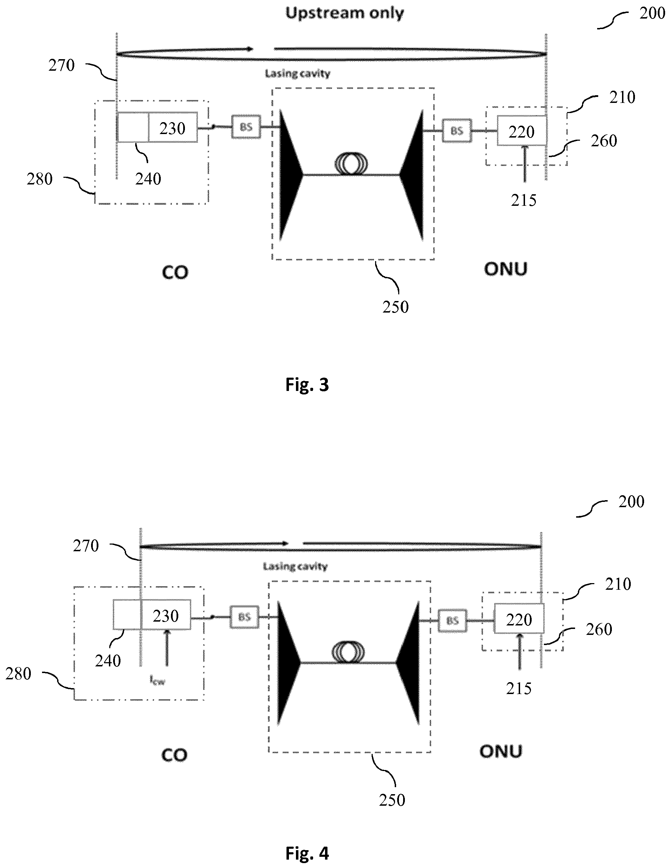

Figures 3 and 4 describe the upstream link of a WDM-PON network using a self-seeded laser source 200, comprising :
- an Optical Network Unit (ONU) transceiver 210 (or upstream transceiver) comprising a first Reflecting Semiconductor Amplifier (RSOA) 220 adapted to generate an optical signal and modulate it according to an upstream electrical signal 215 received by the ONU transceiver 210;
- a Central Office (CO) transceiver comprising a second RSOA 230 and a receiver 240 adapted to receive the data information carried by the optical signal 215, the second RSOA 230 and the receiver 240 been integrated in a single chip 280.

Inside the ONU transceiver 210, the upstream electrical signal 215 modulates the current injected into the first RSOA 220 which modulates the optical signal accordingly. The first RSOA is also adapted to amplify the optical signal before it enters into a WDM-PON 250 in order to compensate the optical losses that could occur online. This WDM-PON 250 links the two ONU and CO transceivers and allows the transport of the optical signal over a distance of up to several kilometers.

The first RSOA 220 has a reflecting element 260 which constitutes the first mirror of the self-seeding laser cavity.

In another embodiment, the first RSOA 220 could be replaced by a Fabry-Pérot laser or by the integration of a RSOA and an electro-absorption modulator, or by other kinds of active devices providing gain and modulation capabilities.

After passing through the WDM-PON 250, the optical signal enters into the second RSOA 230 which comprises a reflecting element 270 adapted to reflect the optical signal and constituting the second mirror of the self-seeding laser cavity. The RSOA 230 is adapted to amplify the optical signal, and adapted to erase data before they go back into the WDM-PON 250 (i.e. after being amplified and reflected on the reflecting element 270). To achieve this, the length of the RSOA and its optical confinement should be large enough. Typically, the length of the RSOA is 1 mm (or at least 700 µm) and the optical confinement is 80% (or at least 20%). The second RSOA 230 and the receiver 240 are integrated in a single chip 280.

To integrate the receiver 240 with the second RSOA 230, a solution is to simply use a bi-electrode device. One section of this bi-electrode device is positively biased for providing gain and ensuring data cancellation (by gain compression, see [R2]) and corresponding to the RSOA section 230 and a shorter section is negatively biased for detecting the incoming signal and corresponding to the receiver section 240.

A positive bias corresponds to applying a positive voltage to the terminals of the electronic section and a negative bias corresponds to applying a negative voltage to the terminals of the electronic section. Typically, a +1.3V voltage is applied for a positive bias (with an current of 10 mA) and a -1V for a negative bias.

Data cancellation is essential for this kind of laser. Due to its significant length, the duration of a photon round trip in the laser cavity is higher than the modulation period of the optical signal which could cause interferences between the modulated optical signal and the signal which comes back after a cycle in the laser cavity.

Since the data cancellation (by gain compression) occurs at the output of the device (typically in the last 100 µm of the device), the receiver section 240 should be close to the mirror which closes the laser cavity. The mirror can be either located after the receiver section 240 of between both sections 230, 240. In any case, it should be at least 100 µm away from the input section.

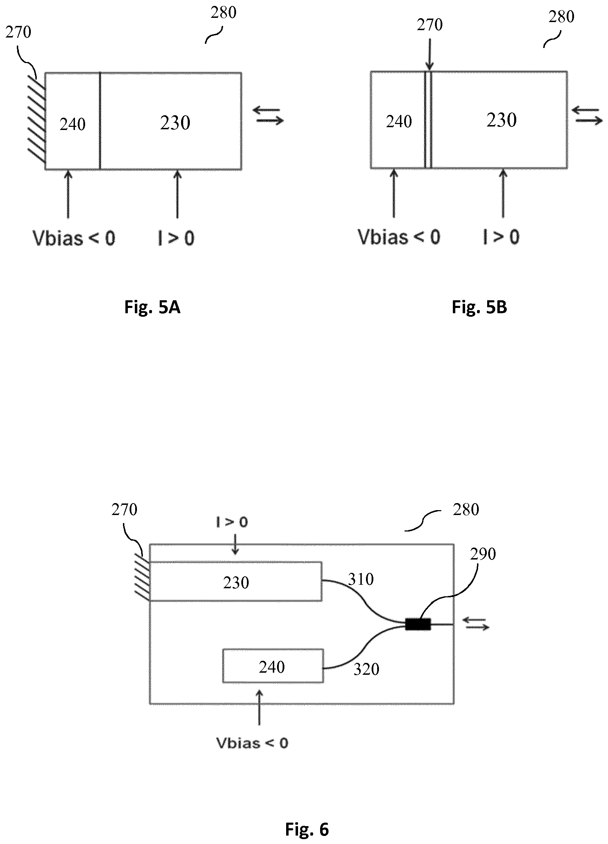

According to a first configuration of the single chip 280, see figures 3 and 5A, the second reflecting element 270 which closes the self-seeding laser cavity, is placed beside the receiver 240 so that the receiver 240 is located between the reflecting element 270 and the RSOA 230. This reflecting element 270 can be a mirror.

According to a second configuration of the single chip 280, see figures 4 and 5B, the second reflecting element 270 is located between both sections, the second RSOA 230 and the receiver 240. In this case, the second reflecting element 270 constitutes a partial mirror reflecting only a part of the optical signal so that the receiver 240 receives the other part. This partial mirror can be either made with an etched gap between both sections, with photonic crystals, or with a Bragg grating.

The advantages of these two configurations is that the optical signal is amplified by the second RSOA 230 before going into the receiver 240, which improves the reception of the data especially after a propagation of the optical signal over a long distance.

In these first and second configurations, current isolation between the sections can be obtained with proton implantation, or even more simply with the etched gap.

According to a third configuration, the single chip 280 comprises a two by one coupler 290, such as a Multi-Mode Interferometer (MMI) adapted to split the optical signal in two substantially identical signals 310 and 320, each containing the data information and one being sent to the receiver 240 and the other being sent to the second RSOA 230. MMIs are often used to split optical signals because they offer low optical losses and are easy to implement.

The coupler 290 is also adapted to couple the receiver section supplied by a negative voltage, and the second section comprising the second RSOA 230 and the second reflecting element 270 supplied by a positive voltage.

In this configuration, the amplifying and detecting sections are even more easily separated from each other, at the expense of a larger chip size.

The RSOA 230 section comprising the second reflecting element 270 is adapted to amplify the optical signal 310, reflect it on the reflecting element and erase data before reinjecting the optical signal 310 into the WDM-PON 250 via the coupler 290. As for the receiver 240 section, it only receives the data information carried by the optical signal 320.

According to an option of the self-seeded laser, band splitters can be added at the input and output of the WDM-PON 250. In this case, the optical signal will be splitted into multiple signals having different frequency bands, each signal carring the data information. The multiplication of channels carring the data information enables backups in case of online transmission problem.

The invention has many advantages. It offers a high flexibility and an innovative solution for WDM PON, by keeping the same upstream transceiver and PON architecture. The single chip is easy, low cost to produce and compatible with the existing architecture. It can easily be integrated in the current access network infrastructure and such architecture can become a standard in the future.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

### REFERENCES LIST

[R1] Q. Deniel, F. Saliou, S. D. Le, P. Chanclou, D. Erasme, R. Brenot, "Amplified RSOA Self-Tuning Laser for WDM PON Using Saturated SOA for Noise Reduction and Data Cancellation", Conference ECOC 2013
[R2] A. Maho, et Al., "Demystification of the Self-Seeded WDM Access", Journal of Lightwave Technology, Vol. 34, Issue 2, p. 776-782, 2016.

## Claims

1. A transceiver for Wavelength Division Multiplexing Passive Optical Network comprising :
- a receiver (240) adapted to receive the data information carried by an optical signal and
- a Reflecting Semiconductor Amplifier (230) for amplifying the optical signal, comprising a reflecting element (270) adapted to reflect the optical signal, the Reflecting Semiconductor Amplifier (230) being adapted to erase data after the optical signal has been amplified and reflected on the reflecting element (270),
**characterized in that**
the Reflecting Semiconductor Amplifier (230) is integrated in a single chip (280) with the receiver (240).

2. The transceiver of claim 1 wherein the receiver (240) and the Reflecting Semiconductor Amplifier (230) are integrated by using a bi-electrode device comprising two sections, one section been positively biased for providing gain and ensuring data cancellation by gain compression and defining the Reflecting Semiconductor Amplifier section (230), and a second shorter section been negatively biased for detecting the incoming optical signal defining the receiver section (240).

3. The transceiver of claim 2 wherein the receiver section (240) is located between the reflecting element (270) and the Reflecting Semiconductor Amplifier section (230).

4. The transceiver of claim 2 wherein the reflecting element (270) is located between the Reflecting Semiconductor Amplifier section (230) and the receiver section (240).

5. The transceiver of claim 4 wherein the reflecting element (270) is made with an etched gap between both sections.

6. The transceiver of claim 4 wherein the reflecting element (270) is made with photonic crystals.

7. The transceiver of claim 4 wherein the reflecting element (270) is made with a Bragg grating.

8. The transceiver of claim 1 or 2 wherein the single chip (280) comprises a two by one coupler (290) adapted to split the optical signal in two substantially identical signals (310 and 320) each containing the data information, one (320) being sent to the receiver (240) and the other (310) being sent to the Reflecting Semiconductor Amplifier (230).

9. The transceiver of claim 8 wherein the two by one coupler (290) is a Multi-Mode Interferometer.

10. A self-seeded laser source (200) for Wavelength Division Multiplexing Passive Optical Network comprising :
- a first Reflecting Semiconductor Amplifier (220) comprising a reflecting element (260), and adapted to generate an optical signal and adapted to modulate it; and
- a transceiver according to one of claims 1-9,
wherein the reflecting elements (260 and 270) form the self-seeded laser cavity.
